# EUROPEAN PATENT SPECIFICATION

(11) **EP 0 443 502 B1**
(45) Date of publication and mention of the grant of the patent: **13.07.1994**
(21) Application number: 91102298.6
(22) Date of filing: 19.02.1991
(51) Int. Cl.: B65B 9/02, B65G 49/07

(54) **Packages for circuit boards and method of taking out the circuit board therefrom**
Verpackungen für Leiterplatten und Verfahren zum Herausnehmen der Leiterplatten
Emballages pour cartes à circuit imprimé et procédé du retrait des cartes de ceux-ci

(30) Priority: 22.02.1990 JP 41779/90
(43) Date of publication of application: 28.08.1991
(73) Proprietor: MATSUSHITA ELECTRIC INDUSTRIAL CO., LTD., Kadoma-shi, Osaka-fu, 571 (JP)
(72) Inventor: Sato, Shoji, Neyagawa-shi, Osaka-fu (JP); Izumi, Yasuo, Ikoma-shi, Nara-ken (JP); Ishimoto, Kazumi, Katano-shi, Osaka-fu (JP); Makino, Yutaka, Kobe-shi, Hyogo-ken (JP)
(74) Representative: Eisenführ, Speiser & Partner

(56) References cited:
- CH-A- 556 769
- DE-A- 2 125 966
- US-A- 4 601 157

## Description

The invention relates to a method for protecting an electric circuit board having electric circuit means of easily oxidizable conductor material from oxidation during storage or transport betwen manufacture of the board and mounting and soldering electric or electronic components onto the board. The invention is further related to a package containing electric circuit boards, a method for taking out such electric circuit boards from cavities of such a package, and to an apparatus for taking out electric circuit boards.

The present invention is particularly concerned with a package for use in transportation of electric circuit boards, in which the electric circuit boards to be mounted with various kinds of electronic components are kept in good condition from the time when the circuit board is only a substrate to the time when the circuit board is completed with various electronic components mounted thereon.

An electric circuit board has an electric circuit of conductive metal such as copper formed on a substrate made of resin, glass or ceramics. The electric circuit board has various kinds of electronic parts including semiconductor elements and other electronic components such as resistors, capacitors or reactors mounted thereon to connect them to each other. Usually, processes for manufacturing an electric circuit board provided with an electric circuit on the substrate is performed in an other factory or company than that where processes for mounting various kinds of electronic components on the electric circuit board is performed. Therefore, an electric circuit board having no electronic parts mounted thereon is merchandized and sold and requires to be stored temporarily and transported to the market.

A conductive metal such as copper which is forming an electric circuit of the electric circuit board is easily oxidized by air, causing difficulties during soldering at a later process and suffering from functioning its desired electrical characteristics. Furthermore, a recognition mark is usually formed in a pattern by the conductive metal on the substrate at the same time when the electric circuit is formed thereon, which recognition mark is utilized, at a later process, to detect the circuit position on the substrate. However, if the conductive material is oxidized, the recognition mark of the conductive metal deforms and makes it difficult for an image recognition machine to detect the recognition mark correctly. Therefore it is important to prevent the conductive metal from being oxidized during storage or transportation of the electric circuit board.

A solder plating or pre-flux applied to the electric circuit, which does not react with air, is conventionally employed to prevent the electric circuit from being oxidized. In addition to the above described effect to protect the conductive metal against the oxidation by air, a solder plating and pre-flux application have the following advantages. In the solder plating application, it is not necessary to remove the solder plating from the electric circuit board for a later process because various kinds of electronic components are fixed to the circuit board by a solder connection at the later process. In the pre-flux application, the pre-flux functions in two ways: one is to prevent the electric circuit from being oxidized until the electric circuit board reaches a process to mount electronic components thereon, and the other is to promote the soldering ability at the later process to solder the electronic components to the electric circuit board.

However, the previous two methods for preventing the conductive metal of the circuit board from being oxidized have a bad effect on the later process. The solder plating method is executed by applying the solder plating all over to the surface of conductive metal including an electric circuit and a recognition mark and results in a very high cost accordingly. When the electronic components and other parts are mounted on the circuit board by soldering at a later process, there appears a disadvantage that a soldering position is not determined exactly. This results in a mis-mounting of electronic components and other parts or degradation in the accuracy of the soldering position. The method using the pre-flux is usually carried out by a way that a desired solder pattern is formed on the pre-flux layer by a screen printing method. The electronic components and other parts are put on the pre-flux layer and are connected to the circuit by a solder refloat process. During the solder refloat process, the pre-flux between the surface of the circuit boards and the solder is heated to boil and then the electronic components and other parts are separated from the surface of the circuit board. This results in a problem that it is not possible to ensure the soldering between the electronic components and the circuit board. When the method using the pre-flux is applied for a circuit board having an electric circuit at the both sides, another problem appears. While one side of the circuit board is initially subjected to the solder refloat process, the whole circuit board is heated to a higher temperature and then the pre-flux at the another side loses a flux function. When the another side of the circuit board is next subjected to the solder refloat process, the pre-flux at the another side does not act as a useful flux and degrades the soldering connection.

On the other hand, one may consider another method that a circuit board is not subjected to a treatment for preventing the oxidation of the conductive metal. The oxidized conductive metal is reduced to metal by a flux having a strong reduction ability before a process of soldering electronic components and other parts in a way described above. However, such a flux generates a halogen compound during the soldering process. The halogen compound must be finally removed by a cleaning process using, for example, flon. This is not desirable in view of the environmental safety.

It is therefore an object of the invention to avoid the various steps of the prior art as discussed before and to provide a method for protecting an electric circuit board, so that these known measures - which have other disadvantages - are not necessary. Further objects of the present invention are to provide a package containing electric circuit boards, and a method as well as an apparatus for taking out the electric circuit boards from the package.

According to the invention, a method for protecting an electric circuit board is characterized by the steps as defined in claim 1. A package containing electric circuit boards to be used in connection with a method according to the invention is defined in claim 4. Furthermore, a method and an apparatus for taking out electric circuit boards from a package are defined in claims 10 and 12.

Packing of food products is already known from EP-A-320 113. Moreover, from US-A-4,601,157 it is already known to apply heat sealing of foam-paper laminates around articles to cushion them against shocks during transport. However, these known solutions are in completely different technical fields.

Preferable embodiments of the present invention are defined in the dependent claims.

Details and features of the present invention will become clear from the following description taken in conjunction with the preferred embodiments thereof with reference to the accompanying drawings throughout which like parts are designated by like reference numerals, and in which:
Fig. 1 is a portion removed perspective view of a package having an electric circuit board accommodated therein according to the present invention;
Fig. 2 is a perspective view of a package having a plurality of neighboring cavities in which each one of electric circuit board is accommodated according to the present invention, wherein said package is partly opened;
Fig. 3 is a schematic sectional view of a package having an electric circuit board accommodated therein on a large scale according to the present invention;
Fig. 4 is a schematic sectional view of an alternation of the package on a large scale in which the lower and upper sheet are composed of additional adhesive layers according to the present invention;
Fig. 5 is a schematic sectional view of an alternation of the package of the present invention on a large scale in which the lower sheet is composed of rigid material and is formed with a plurality of convex recesses, or cavities, for receiving the electric circuit board;
Fig. 6 is a schematic view of an electric circuit board taking out device according to the present invention;
Fig. 7 is a schematic view of an alternation of the electric circuit board taking out device of Fig. 1 on a large scale, in which a punching device is employed for cutting down the combined part;
Fig. 8 is a schematic view of a separation roller of the Fig. 7, viewed in the package conveyance direction, according to the present invention;
Fig. 9 is a plan view of a portion of a package having a plurality of circuit boards accommodated therein according to the present invention, wherein the cavities are formed in a ladder pattern by the bonded area;
Fig. 10 is a schematic view of an alternation of the electric circuit board taking out device according to the present invention, wherein an iron heater is provided;
Fig. 11 shows a plan view of a package having two kinds of bonded area according to the present invention;
Fig. 12 is a schematic view of an alternation of the electric circuit board taking out device according to the present invention, wherein an ultraviolet ray irradiation device is provided; and
Fig. 13 is a plan view of a package having a plurality of cavities in which each one of electric circuit board accommodated therein according to the present invention, wherein the area to be subjected with an ultraviolet ray irradiation is shown by imaginary lines.

### DETAILED DESCRIPTION OF THE PREFERRED EMBODIMENTS

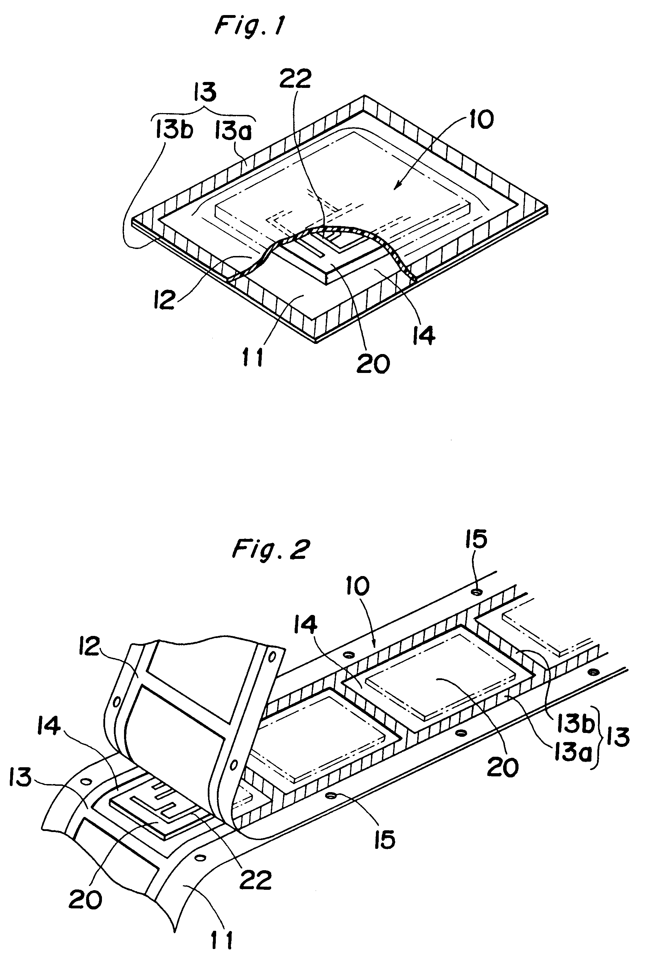

Referring to Fig. 1, a package 10 according to the present invention is shown, which includes a lower sheet 11 and an upper sheet 12 which are made of a transparent and thin film or sheet material (both sheet and film material are referred to as a sheet hereinafter) in a rectangle form and are adhered to each other at the periphery by a fusion bonding technique so as to form a bonded area 13. The bonded area 13 is provided at shaded area shown in Fig. 1. The lower and upper sheets 11 and 12 are made of a gas impermeable material which prevents gas such as oxygen from seeping therethrough. A cavity 14 is formed at a thin space between the lower sheet 11 and upper sheet 12, and is surrounded by the bonded area 13. The cavity 14 encloses a circuit board 20 formed in a rectangular shape.

The circuit board 20 is provided with an electric circuit 22 composed of a conductive metal, such as a copper, which may be easily oxidized. The circuit 22 may not be applied with any oxidation preventive treatment such as a pre-flux or solder plating, and thus is covered with nothing. Therefore the conductive metal of circuit is bare.

According to the present invention, the cavity 14 is in a vacuum state or filled with a non-oxidizing, inert gas such as nitrogen, to prevent the conducting metal from oxidization.

The circuit board 20 enclosed in the package 10 is in a usual structure and is made of a conventional material used in usual electronic devices. For example, a circuit board having either a circuit at one side or on both sides, or a plurality of circuits integrated therein can be used. The circuit board has a substrate composed of resin, glass or ceramics which is commonly used in the electronic devices. A copper is used in the electric circuit 22 as the conductive material, but is easy to be oxidized. Other metals are also applicable. Furthermore, any other metal resistant to oxidation such as gold is applicable for the circuit 22 in combination with the conductive and easy to be oxidized metal.

The substrate of circuit board 20 can be in an arbitrary thickness and size in accordance with the application, and is about 0.4 - 2.0 mm thick in the usual circuit board for use in mounting of semiconductor elements. As the lower and upper sheets 11 and 12 forming the package 10, a gas impermeable material such package materials as polypropylene or polyethylene which is widely used in the various field of electronic devices or the package industries are applicable. The sheet materials used are about 0.01 - 0.1 mm thick.

For the sake of fusion bonding at the bonded area 13, thermal melting adhesives are used for the lower and upper sheets 11 and 12.

If the flexible materials is used for the lower and upper sheet 11 and 12, the package can wrap the circuit board 20 with some projections.

If a transparent material is used for the lower and upper sheets 11 and 12, it is possible to inspect the circuit board 20 in the cavity 14 visually from the outside of the package 10.

If a plastic material is used for the lower and upper sheets 11 and 12, it is possible to form a concave portion, or a recess, in the sheet 11 or 12 previously and the circuit board 20 is received in the recess thereof.

If a rigid material is used for the lower and upper sheet 11 and 12, it is possible to protect the circuit board 20 inside the package 10 against the violent stress from the outside during the transportation. The materials for the lower and upper sheets 11 and 12 can be composed of a multi-layers comprising a plurality of synthetic resin or any other materials. The lower and upper sheets 11 and 12 can be composed of the same material or of different materials according to their required function.

As mentioned above, the lower and upper sheets 11 and 12 are adhered to each other at the bonded area 13 to form an air tight cavity 14 by using common means of bonding usual sheet materials such as a viscous agent or adhesive agent besides the fusion bonding technique. The viscous agent or adhesive agent is applied to the lower and upper sheets 11 and 12 only at the portion to form the bonded area 13. Another method is to apply the viscous agent or adhesive agent to all over the sheet materials 11 and 12 at both sides facing each other, and to apply heat or pressure only at the portion to form the bonded area 13. The viscous agent or the adhesive agent usually comprises epoxy resin and acrylic resin, for example.

The package 10 is formed by adhering the lower and upper sheets 11 and 12 to each other at the periphery to form the frame-like cavity 14 as shown in Fig. 1. Beside this structure, there are other structures available for the use in the package 10 according to the present invention. One structure is that a sheet material in a pipe form is cut at a given length and is sealed at the both ends. Another structure is that a sheet material in a sack form is sealed at the top opening. Various sealing structure, composed of sheet materials, employed in the package industry is applicable.

To make the cavity 14 in the package 10 a non-oxidizing atmosphere, the lower and upper sheets 11 and 12, having the circuit board 20 placed therebetween, are adhered to each other tightly at the bonded area 13 in a non-oxidizing atmosphere. But the same result is also achieved by the following steps: the circuit board 20 is placed in the cavity 14 between the lower and upper sheets 11 and 12 in a normal air environments; the cavity 14 is evacuated or filled with an inert gas through an opening formed partially at the bonded area 13; and the opening is closed in an air tight manner.

It is possible to take out the circuit board 20 from the package 10 by peeling the lower and upper sheets 11 and 12 apart to separate mechanically the bonded area 13 formed by a fusion bonding technique or an adhesive agent, or by cutting off or punching out the lower and upper sheets 11 and 12 along a line inside of the bonded area 13. When the viscous agent used at the bonded area 13 has such a property as to lose an adhesive property under the ultraviolet ray, it is possible to separate the lower and upper sheets 11 and 12 from each other by irradiating the ultraviolet ray at the bonded area 13.

The package 10 usually has one circuit board 20 enclosed therein. However, it is possible to receive a plurality of circuit boards 20 in one cavity 14 thereof or to make a plurality of calvities 14 so as to neighbor each other within one package 10. In either case, each cavity 14 accommodates one circuit board 20 in an air tight manner. The cavities 14 forming a package 10 may be aligned in a line as in a belt, or they may be aligned vertically and horizontally in a plain.

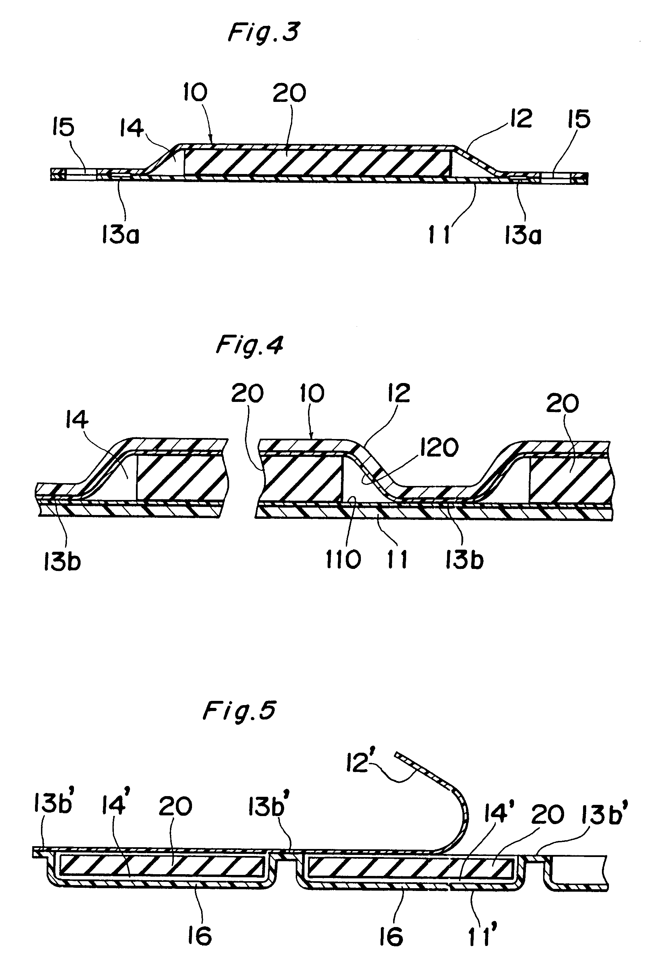

Referring to Figs. 2 and 3, a package 10 in a long rectangular form is shown, which has a plurality of cavities 14 formed individually therein. In each of cavities 14, a circuit board 20 is accommodated. The package 10 is formed by the lower and upper sheet 11 and 12 in a long rectangular form adhered to each other at a bonded area 13. The bonded area 13 has a form of ladder defined by two opposing parallel portions 13a and crossing portions 13b extending between the parallel portions 13a.

The package 10 having the bonded area 13 in a ladder form has a plurality of rooms enclosed therein. Each of rooms acts as a cavity 14 and encloses a circuit board 20 in an air tight manner. The package 10 has perforations 15 at a given pitch along opposite sides and outside the bonded area 13a. The perforations 15 are utilized for the continuous conveyance of the lower and upper sheets 11 and 12 when the package 10 is produced. During the continuous conveyance, the lower and upper sheets 11 and 12 receive the circuit board 20 and are adhered to each other at the bonded area 13. As will be described later, the perforations 15 are also used for automatic conveyance of the lower and upper sheets 11 and 12 together at the time when the circuit boards 20 are taken out from the package 10.

As shown in Fig. 3, the lower sheet 11 is flat and stiff while the upper sheet 12 is flexible and deformed along with the shape of the circuit board 20. In such a way, it is preferable to employ the lower sheet 11 and upper sheet 12 of a combination of material qualities suitable for the aimed function.

The package 10 mentioned above is in a structure to bond the lower and upper sheets 11 and 12. Such a structure makes it easy to take out the circuit board 20 from the package 10 by separating mechanically the lower and upper sheets 11 and 12. A package material in a pipe form can have the circuit board 20 inserted through one opening and is sealed repeatedly at a given distance to form the plurality of cavities 14 each of which has the circuit board 20 enclosed therein.

The lower sheet 11 and upper sheet 12 of long sheet material can form a bonded area 13 in a ladder form by the following way. During the continuous conveyance of the lower and upper sheets 11 and 12, the sheets 11 and 12 are adhered continuously at the both side edges through a fusion bonding technique using a heating roller and are simultaneously bonded along a line crossing the sheets 11 and 12 with a heater which attaches intermittently to the sheets 11 and 12 along a line in a given distance from neighboring lines. In this way the bonded area 13 in a ladder form is obtained.

Another way to make the bonded area 13 in a ladder form is that the sheets 11 and 12 are repeatedly heated with a heater having a frame with a configuration which is the same as that of one block of the bonded area 13 in a ladder form. The package 10 in a ladder pattern shown in Fig. 2 is preferable from the viewpoint of the continuous manufacturing and a small area of the bonded area 13. However, other pattern of the bonded area 13, such as independent rectangles aligned in a line may be used.

It is possible to make independently a cavity 14 at the lower and upper sheets 11 and 12. Any other package method or mechanism available for various items can be applicable for the manufacturing method of the package according to the present invention.

Referring to Fig. 4, another embodiment according to the present invention is shown, in which a package 10 in a long sheet has a plurality of cavities 14 formed individually therein through an operation of an adhesive agent but not through an operation of thermal melting adhesion. The materials of lower and upper sheets 11 and 12 are over-coated at the both sides facing each other with adhesive layers 110 and 120.

The lower and upper sheet materials have a plurality of circuit boards 20 inserted therebetween and are pressed at a bonded area 13 at which the lower and upper sheets 11 and 12 adhere to each other so as to make a package 10 having a plurality of cavities. Thus, the bonded area 13 has a pattern of a ladder. It is necessary to make the adhesion strength of adhesive layers 110 and 120 strong enough. Otherwise the bonded area 13 may be separated during the transportation of the package and consequently the atmosphere in the cavity 14 is changed from the non-oxidizing atmosphere to air. The package in such a structure makes it easier to take out the circuit board 20 by pulling off the sheets 11 and 12 apart, than the package having cavities 14 formed by a fusion bonding technique.

Referring to Fig. 5, other embodiment according to the present invention is shown, in which a lower sheet 11′ is composed of a material having a capability of shape forming and has a recess 16, or convex portion, in a size matching with the size of an electric circuit board 20. The recess 16 acts as a cavity 14′ similar to the cavity 14 of the above described embodiments. An upper sheet material 12′ is composed of a material relatively thin and covers the lower sheet 11′. The lower and upper sheets 11′ and 12′ are adhered to each other at a bonded area 13′ through a fusion bonding technique so as to form a cavity 14′ at the recess 16. The package 10 in this structure can ensure the positioning of the circuit board 20. The circuit board 20 is put in the cavity 14′ at the recess 16 composed of a rigid material and is protected effectively from the external stress.

As explained above, a package 10 shown in Fig.1 has a circuit board 20 enclosed individually therein. A plurality of packages 10 are packed in any of suitable box or container, and are transported or stored. At a time to use the circuit board 20, the circuit board 20 can be easily taken out from the package 10 by breaking the package 10. In this case it is possible to take out the circuit board 20 automatically by using any suitable machine for the purpose.

A package 10 shown in Fig. 2 is in a long sheet type and can be folded or rolled into a small pack. It is convenient to store or transport the small pack including a plurality of circuit boards 20. When the circuit boards 20 are on sale, a long sheet package 10 can be cut into a small package having a given amount of circuit boards 20. It is convenient to handle a small package having a given amount of circuit boards 20 enclosed air-tightly therein.

To take out the circuit boards 20 from the package 10 in a long sheet type, the adhesive ability at the bonded area 13 is weakened and the cover sheet 11 is peeled off, while the package 10 in a long sheet type being conveyed continually. Furthermore the used sheets 11 and 12 can be collected at the same time.

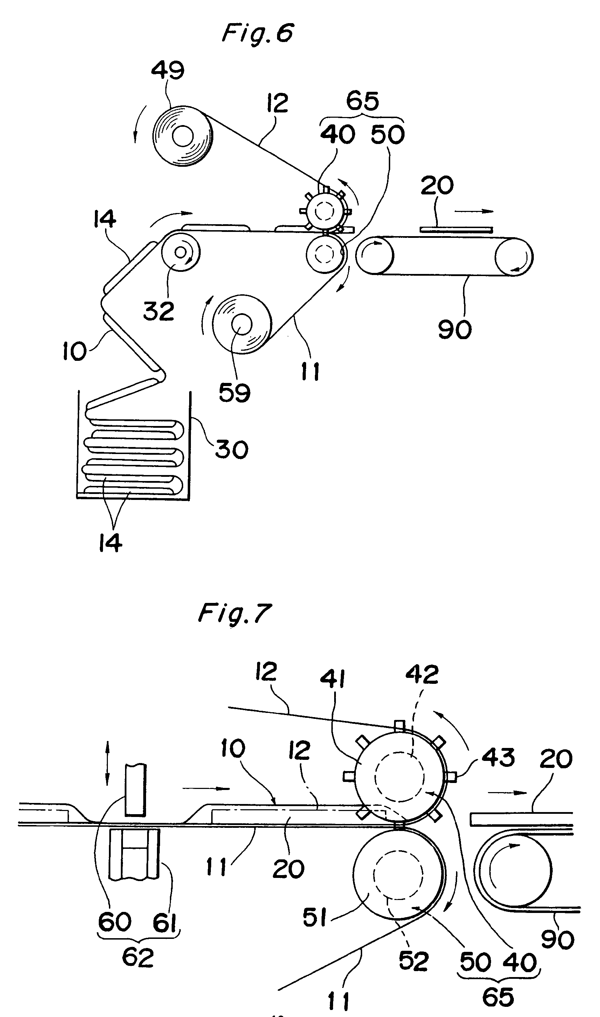

Referring to Fig. 6, a machine for taking out a plurality of circuit boards 20 from a package 10 in a long sheet type is shown. The package 10 in a long sheet type can be folded alternatively at flexible portions between each cavity 14 having the circuit board 20 therein, and is stored in a stock container 30.

The package 10 is pulled out from the stock container 30 from one end of the folded package 10, and is conveyed horizontally over a guide roller 32 toward the gap between an upper roller 40 and a lower roller 50 with each of lower and upper sheets 11 and 12 facing down and up, respectively. The upper roller 40 and the lower roller 50 construct a pair of separation rollers 65. When the package 10 reaches the separation rollers 65, rollers 40 and 50 pull the upper and lower sheet 12 and 11 so as to separate them. Each sheets 12 and 11 separated by the separation rollers 65 is conveyed to and wound up by the collection rollers 49 and 59, respectively.

During the separation of the lower and upper sheets 11 and 12, the electric circuit boards 20 are removed from the lower and upper sheets 11 and 12 and is carried ahead of the separation rollers 65. The carried circuit board 20 goes into the next process, or station, through the circuit board collection mechanism such as a roller conveyer 90. The machine explained in the above can take out the circuit board 20 from the package 10 in a long rectangular shape automatically and continuously.

In the above mentioned embodiment, the lower and upper sheets 11 and 12 adhered each other at the bonded area 13 are separated only by pulling the lower and upper sheets 11 and 12 by the lower and upper roller 50 and 40 of separation rollers 65, respectively. This mechanism is applicable only for the package having the bonded area 13 adhered by usual adhesive agent which can be easily detached. However, if the package 10 has the bonded area 13 which is firmly bonded by a stronger bonding means such as by the fusion bonding, it is preferable to employ the following apparatuses.

Referring to Figs. 7, 8 and 9, embodiments of sheet removing apparatus according to the present invention are shown, which have the same basic structure as that of the machine shown in Fig. 6.

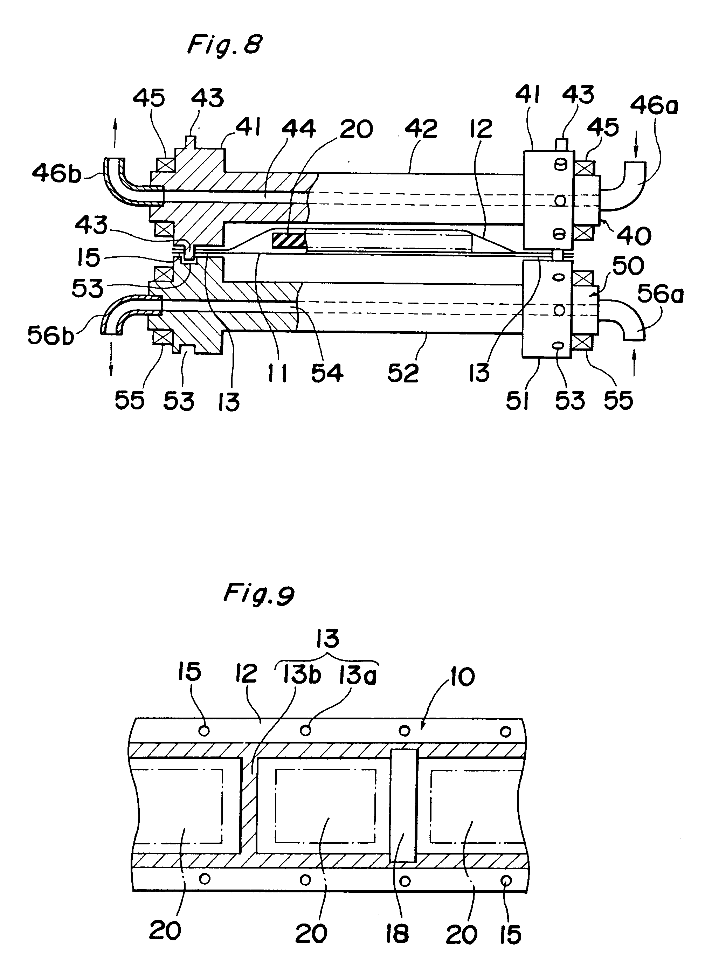

According to the apparatus shown in Fig. 7, a cutting device 62 has an upper punch 60 and a lower punch 61 which are provided before the separation rollers 65 such that the package 10 goes through the clearance between the upper punch 60 and the lower punch 61. The upper punch 60 can reciprocate in a vertical direction and fit in the lower punch 61 which is positioned under the upper punch 60. A crossing portion 18 of the package 10 is cut off by the upper punch 60 and the lower punch 61 through the downward movement of the upper punch 60 as shown in Fig.9.

Referring to Fig. 8, a detailed structure of the separation rollers 40 and 50 is shown. The separation rollers 65 is composed of the upper roller 40 and the lower roller 50. The rollers 40 and 50 are each supported rotatably at the opposite ends with bearings 45 and 55. At each end two rollers 50 and 40, end rolls 41 and 51 of a large diameter are provided adjacent the bearings 45 and 55, respectively. Provided between the end rolls 41 is a central shaft 42 of a small diameter. Similarly, a central shaft 52 is provided between the end rolls 51.

The package 10 is sandwiched between upper and lower rollers 40 and 52 with opposite side ends of the bonded area 13 and perforations 15 pressure fitted between the end rolls 41 and 51. The end roll 41 has sprockets 43, and the end roll 51 has holes 53 for receiving the sprockets 43. The separation rollers 40 and 50 rotate with the rotation of the end rolls 41 and 51 while the sprockets 43 mesh into the corresponding holes 53. The package 10 sandwiched between the separation rollers 40 and 50 is meshed at the perforations 15 by the sprockets 43 of the end roll 41 and is conveyed forward with the rotation of the end roll 41. The package 10 at the cavity 14 for the circuit board 20 goes through the central shaft 42 in a small outside diameter without collision into the separation rollers 40 and 50.

The separation rollers 40 and 50 have through holes 44 and 54 formed along with the central axis thereof. The through holes 44 and 54 are connected at the both ends thereof to an external heating source (not shown in the Fig.8) through rotary joints 46a, 46b, 56a and 56b installed at the both ends of separation rollers 40 and 50. A heating medium such as warm air or hot water supplied from the heating source enters into each one end of the rotary joint 46a and 56a, and exits from another ends of the rotary joint 46b and 56b. During the circulation of the heating medium in the through holes 44 and 54, the separation rollers 40 and 50 are heated, and the end rolls 41 and 51 are also heated. The package 10 is sandwiched at the both sides between the end rolls 41 and 51 of the rollers 40 and 50, respectively. The bonded area 13 is heated at the both sides and is released from the adhesion effect of the fusion bonding. The sheet materials 11 and 12 having the bonded area 13 released from the adhesion are conveyed along the separation rollers 40 and 50 and thus are easily separated from each other. The heated end rolls 41 and 51 make only the both side of the bonded area 13 heated to weaken the adhesion. The crossing portion 18 of bonded area 13 is already cut off. Therefore the separation between the lower and upper sheets 11 and 12 can be easily executed.

According to the above described apparatus, the end rolls 41 and 51 are heated up to a temperature at which the bonded area 13 adhered through a fusion bonding technique is released from the adhesion. The temperature of the heating medium at the heating source is practically different with the materials of the sheets 11 and 12, but it is sufficient to heat up the heating medium at about 60 to 100 °C.

The above embodiment explains the method for making the bonded area 13 released from the adhesion. The bonded area 13 in a ladder form is cut off at the portion crossing the package 10 with the upper punch 60. The both sides of the bonded area 13 are released from the adhesion by heating with heated end rolls 41 and 51. In this way the lower and upper sheets 11 and 12 are separated efficiently from each other under the continuous conveyance of the package 10. Consequently, the circuit board 20 is taken out easily from the package 10.

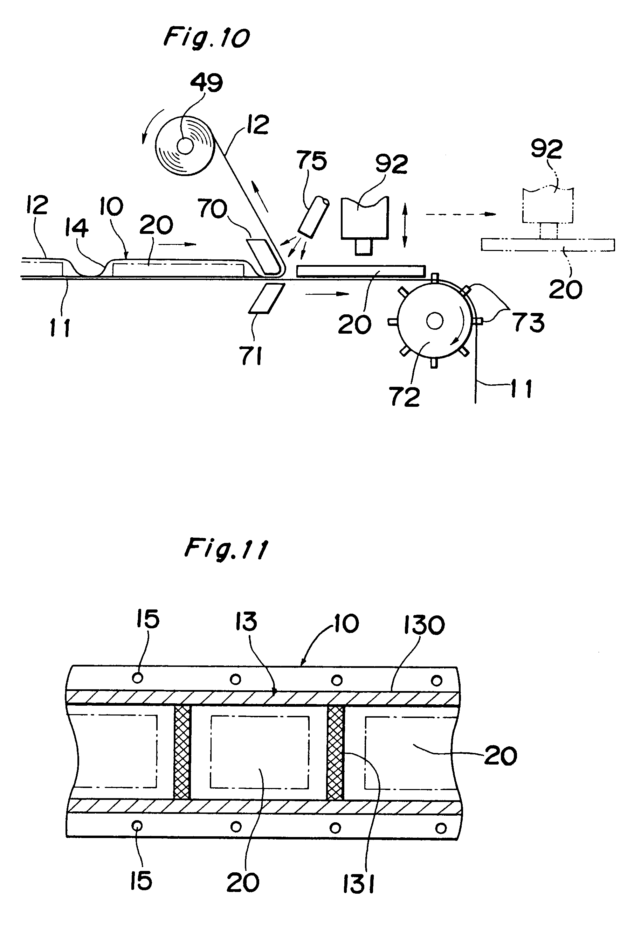

Referring to Fig.10, an apparatus for taking out the circuit board 20 according to another embodiment is shown. In this embodiment, a heated element 70 at an upper position and a heated element 71 at a lower position are used in place of the separation rollers which can be heated freely. The heated elements 70 and 71 are heated by any heating means such as an electric heater and are formed, for example, by iron. The heated elements 70 and 71 attach to the package 10 at the both sides thereof and make the bonded area 13 released from the adhesion by a fusion bonding technique. After the bonded area 13 is released from the adhesion by the fusion bonding, the upper sheet material 12 at an upper position is conveyed upward along the heated element 70 and is rolled at a collection roller 49. The lower sheet 11 at a lower position is conveyed horizontally while carrying the circuit board 20 thereon.

An ion generating nozzle 75 is installed at a place where the upper sheet 12 at an upper position is separated from the lower sheet 11. Ions generated from the ion generating nozzle 75 are blown to the upper sheet 12 at the separating portion and remove the static electric charge existing on the package during works. This prevents the static electric charge from remaining in the circuit board being carried to the next process.

The circuit board 20 on the upper sheet 12 is picked up from the lower sheet material 11 by an air-suction nozzle mechanism 92 and conveyed to the next station by the movement of the air-suction nozzle mechanism 92. The upper sheet 12 having the circuit board 20 picked up therefrom is collected at a downwards place through a rotating roller 72 equipped with a sprocket 73. The package 10 and the upper sheet 12 are driven by a driving force of the rotating roller 72.

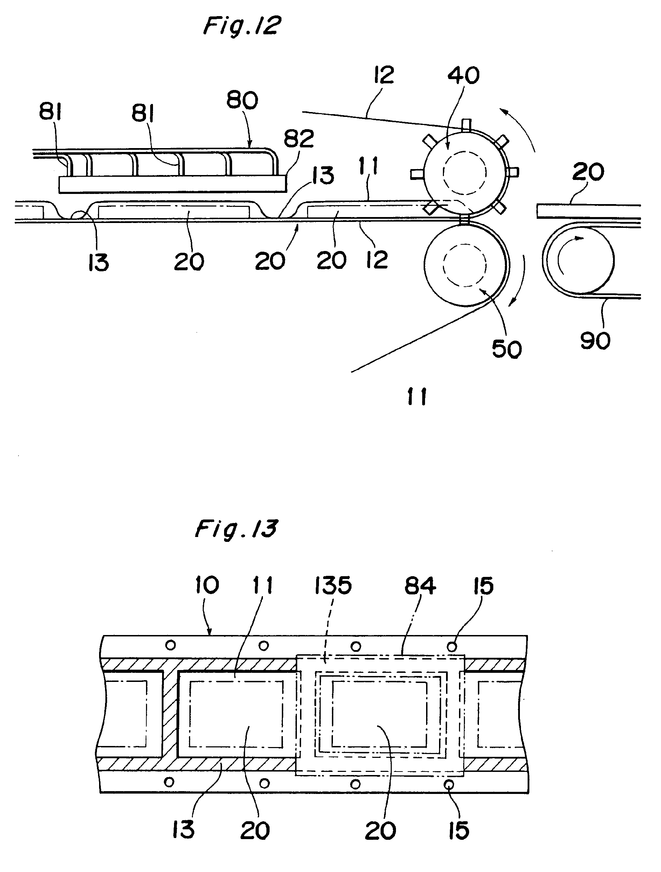

Referring to Fig. 11, an embodiment according to the present invention providing a modified bonded area is shown. In this embodiment, a bonded area 13b in a ladder form is formed at the both sides 130 through a fusion bonding technique, and is bonded at a crossing portion 131 with an adhesive agent. The lower and upper sheets 11 and 12 have adhesive layers 110 and 120 applied thereto as shown in Fig. 4 and are pressed at the crossing portion 131 to be a part of the bonded area 13b. The upper and lower sheets 11 and 12 are adhered to each other at their both sides through a fusion bonding technique.

When a circuit board 20 is taken out from a package 10 in such a structure shown in Fig. 11, it is not necessary to cut down the bonded portion 13b at the portion 18 by the cutting punches 60 and 61 as shown in Figs. 7 and 8. The package 10 shown in Fig. 11 requires operations to release the both sides 130 adhered by the fusion bonding with the heated separation rollers 41 and 51 or heated elements 70 and 71. On the other hand, the crossing portion 131 can be easily released from the adhesion by pulling mechanically to separate the sheets 11 and 12 from each other and does not require the punching work.

Referring to Figs. 12 and 13, an embodiment according to the present invention in which a package 10 is adhered at a bonded area 13 with an adhesive agent which loses an adhesion ability under irradiation of ultraviolet ray is shown. The package 10 is composed of the lower and upper sheets 11 and 12 having adhesive layers 110 and 120 respectively applied on each surface facing to each other, as shown in Fig. 4. The adhesive layers 110 and 120 are made of an adhesive agent which loses the adhesion ability under irradiation of ultraviolet ray.

Separation rollers 40 and 50 for taking out a circuit boards 20 are in a structure essentially similar to those of Figs. 7 and 8. However, it is not necessary to have a heating means for the separation rollers 40 and 50. An ultraviolet ray irradiation apparatus 80 is installed at a position over a package 20 and in front of the separation rollers 40 and 50. In the ultraviolet ray irradiation apparatus 80, a plurality of optical fibers are arranged along with a supporting frame 81 facing to the surface of a package 10. The plurality of optical fibers are connected to an ultraviolet ray source (not shown in Fig. 12). The plurality of optical fibers 81 irradiate ultraviolet ray in a frame pattern on the package 10.

As shown in Fig. 13, when a bonded area 13 is irradiated with the ultraviolet ray in a frame pattern (shown by imaginary lines) at a bonded area 135 (shown by dotted lines), the adhesive agent loses the adhesion ability. Then, the lower and upper sheets 11 and 12 are released from the adhesion to each other. After that, the sheets 11 and 12 are easily separated from each other by the separation rollers 40 and 50 as mentioned above, and the circuit board 20 is easily taken out from the package 10. The area of the package 10 on which the ultraviolet ray is irradiated, where the bonded area 13 loses the adhesion ability by one cycle of the ultraviolet ray irradiation, is limited to an area of one block of the bonded area 13 surrounding the cavity 14 containing one circuit board 20 therein. The bonded area 13 to be released from the adhesion is shifted sequentially as synchronized with the movent of the package 10. It is allowable to extend the ultraviolet ray irradiation area wider than the area of bonded area 13 to be released from the adhesion if the irradiation area covers the necessary area.

The circuit boards 20 taken out from the package 10 through the various methods explained above are used for mounting on usual electronic components. For example, if the circuit board 20 having an adhesive solder screen-printed thereon has then various electronic components mounted on the adhesive solder and followed by a solder refloat treatment, the electronic components is soldered to the electric circuit 22. Furthermore, if a circuit board 20 is of a type with double sides circuit, the electronic components are soldered to the electric circuit of the reverse side in the same way as that on another side.

It is preferable to execute the solder floating treatment in a non-oxidizing atmosphere such as nitrogen gas in order to protect the conductive metal of the circuit 22 from being oxidized because the conductive metal is exposed, according to the present invention. This method makes it possible to prevent the conductive metal of the circuit 22 from being oxidized during a period from the time when the circuit board has been manufactured to the time when the mounting of electronic components is completed. Therefore it is possible to solder the electronic components without using any flux and thus saves a cleaning work for the flux.

## Claims

1. A method for protecting an electric circuit board having electric circuit means of easily oxidizable conductor material from oxidation during storage or transport between manufacture of the board and mounting and soldering electric or electronic components onto the board;
characterized by
- placing the electric circuit board in a package in a non-oxidation atmosphere during storage or transport, the package comprising a lower sheet made of gas impermeable material, an upper sheet made of gas impermeable material, a bonded area on the periphery of the surfaces of said sheets which oppose each other, at least one cavity defined between said lower sheet and said upper sheet and enclosed by said bonded area in an air-tight manner, and the electric circuit board resting in said cavity without electric or electronic components during storage or transport in a non-oxidation atmosphere in said cavity; and
- taking out the electric circuit boards from the cavities shortly before mounting and soldering the components onto the board.

2. A method as claimed in claim 1 in which said non-oxidation atmosphere is an inert gas.

3. A method as claimed in claim 1 in which said non-oxidation atmosphere is an air-evacuated atmosphere in said cavity.

4. A package containing electric circuit boards to be used in connection with a method according to any preceeding claim,
characterized by
a lower sheet (11) made of gas impermeable material;
an upper sheet (12) made of gas impermeable material;
a bonded area (13) on the periphery of the surfaces of said sheets (11, 12) which oppose each other;
at least one cavity (14) defined between said lower sheet (11) and said upper sheet (12) and enclosed by said bonded area (13) in an air-tight manner;
an electric circuit board (20) in said cavity (14) and having thereon electric circuit means (22) of easily oxidizable conductor material and being free of electric or electronic components; and
a non-oxidation atmosphere in said cavity.

5. A package as claimed in claim 4 in which said gas impermeable material is resinous material and said bonded area (13) is fusion-bonded by the application of heat.

6. A package as claimed in claim 4 in which said bonded area (13) is fused and adhered by fusion bonding technique.

7. A package as claimed in claim 4 in which said upper and lower sheets further comprise viscous and adhesive layers (110, 120) on opposed surfaces thereof at least in said bonded area (13).

8. A package as claimed in claim 7 in which said lower and upper sheets (11, 12) are press-adhered to each other in said bonded area (13).

9. A package as claimed in claim 4 in which said lower sheet (11) is made of a rigid material having at least one convex recess (16) therein for receiving said electric circuit board (20).

10. A method for taking out electric circuit boards from cavities (14) of a package (10) according to any of claims 1 to 3,
characterized by the steps of:
sequentially pulling said elongated sheets (11 and 12) in opposite directions to separate said sheets from each other while said bonded area (13) is released; and
taking out said electric circuit boards (20) from said separated sheets (11 and 12).

11. A method as claimed in claim 10 further comprising the steps of:
conveying said package (10) between a pair of separation rollers (40 and 50);
winding up said sheets (11 and 12) individually as the sheets are separated by said pulling; and
taking out said electric circuit boards (20) exposed from said separated sheets (11 and 12).

12. An apparatus for taking out electric circuit boards (20) of a package (10) in accordance with claim 1, in which the circuit boards (20) are accommodated in cavities (14) arranged in a continuous line between a lower sheet (11) and an upper sheet (12) of impermeable material bonded together and forming the package (10), having perforated holes (15) on both sides of the cavities;
characterized by
a guide means (32) for guiding said package (10);
a separation means (65) for pulling and separating said sheets (11 and 12) of said package (10) from each other, the separation means comprising
an upper roller (40) having separation rollers (41) provided on opposite ends thereof with a plurality of sprockets (43) at a predetermined distance on the outer circumference according to the perforated holes (15) formed on said package (10); and
a lower roller (50) having holes (53) formed on the outer circumference thereof corresponding to said sprockets (43), said package (10) being hold between said rollers (40 and 50) such that said sprockets (43) mesh into said holes (53) through said perforated holes (15) of said package (10);
a winding means (49 and 59) for winding up said separated sheets (11, 12) of the package (10); and
a collection means (90) for collecting said electric circuit boards (20) from said opened package (10).

13. Apparatus as claimed in claim 12,
wherein said separating means (65) further comprises a central shaft (42) having a through hole (44) extending from one end to another end thereof, provided on said upper roller (40); a central shaft 852) having a through hole (54) extending from one end to another end thereof, provided on said lower roller (50); and means for providing heated media circulating inside said through holes (42 and 52) via said ends thereof resulting in heating said upper and lower rollers (41 and 51) to melting the bonded area (13a) along opposite sides of said package (10) during separation.

14. Apparatus as claimed in claim 12 or 13,
further comprising a cutting device (62) having an upper punch (60) and a lower punch (61) provided before the separation means (65) such that the package (10) goes through the clearance between said upper punch (60) and said lower punch (61); said upper punch (60) being provided to reciprocate vertically to fit in said lower punch (61); whereby during the separation, said cutting device (62) cuts off said package (10) at a portion (18) of the bonded area (13b) crossing the package (10).

15. An apparatus as claimed in any of claims 12 - 14,
further comprising a pair of heating means (70 and 71) before said separation unit (65); said heating means (70 and 71) being moved toward each other to hold said package (10) therebetween at a portion of the bonded area (13b) crossing said package (10); whereby during separation, said heating means (70 and 71) press said package (10) at said bonded area (13b) for melting.

16. An apparatus as claimed in claim 15,
further comprising an ion generating means (75) between said heating means (70 and 71) and said separation means (65) for removing static electric charge from said electric circuit boards (20).

17. An apparatus as claimed in any of claims 12 - 16,
further comprising an ultra-violet ray generation means (80) for irradiating ultra-violet rays on said package (10) at an area including one cavity (14) surrounded by bonded areas (135) before said separation means (65).

## Patentansprüche

1. Verfahren zum Schützen einer elektrischen Schaltungsplatine; die elektrische Leiterbahnen aus leicht oxydierbarem Material aufweist, gegen Oxydation während der Lagerung und des Transports zwischen der Herstellung der Schaltungsplatine und dem Bestücken der Schaltungsplatine mit und Verlöten von elektrischen oder elektronischen Bauelementen;
gekennzeichnet durch
- Einlegen der elektrischen Schaltungsplatine in eine Packung mit nichtoxydierender Atmosphäre, wobei die Packung eine untere Folie und eine obere Folie aus gasundurchlässigem Material, einen Versiegelungsbereich am Umfang der einander gegenüberliegenden Folien und mindestens eine zwischen der unteren und der oberen Folie durch den Versiegelungsbereich luftdicht abgeschlossene Tasche aufweist, und wobei die elektrische Schaltungsplatine ohne elektrische oder elektronische Bauelemente in dieser Tasche während der Lagerung oder des Transports in einer nichtoxydierenden Atmosphäre ruht; und
- Herausnehmen der elektrischen Schaltungsplatine aus den Taschen kurz vor dem Bestücken der Schaltungsplatine mit und Verlöten von Bauelementen.

2. Verfahren nach Anspruch 1,
dadurch gekennzeichnet, daß die nichtoxydierende Atmosphäre aus einem Inertgas besteht.

3. Verfahren nach Anspruch 1,
dadurch gekennzeichnet, daß die nichtoxydierende Atmosphäre aus einer luftleeren Atmosphäre in der Tasche besteht.

4. Packung mit elektrischen Schaltungsplatinen zur Benutzung in Verbindung mit einem Verfahren nach einem der vorstehenden Ansprüche, gekennzeichnet durch
eine untere Folie (11) aus gasundurchlässigem Material;
eine obere Folie (12) aus gasundurchlässigem Material;
einen Versiegelungsbereich (13) am Umfang der einander gegenüberliegenden Folien (11, 12);
mindestens eine zwischen der unteren Folie (11) und der oberen Folie (12) durch den Versiegelungsbereich (13) luftdicht abgeschlossene Tasche (14);
eine elektrische Schaltungsplatine (20) in der Tasche (14), wobei die elektrische Schaltungsplatine elektrische Leiterbahnen (22) aus leicht oxydierbarem Material aufweist, aber noch keine elektrischen oder elektronischen Bauelemente trägt; und
eine nichtoxydierende Atmosphäre in der Tasche.

5. Packung nach Anspruch 4,
dadurch gekennzeichnet, daß das gasundurchlässige Material ein Kunstharz ist und daß der Versiegelungsbereich (13) durch Zuführen von Wärme hitzeversiegelt ist.

6. Packung nach Anspruch 4,
dadurch gekennzeichnet, daß die Verklebung im Versiegelungsbereich (13) durch eine Schmelzversiegelung erfolgt.

7. Packung nach Anspruch 4,
dadurch gekennzeichnet, daß die obere und die untere Folie zumindest im Versiegelungsbereich (13) mit einander gegenüberliegenden, klebrigen Schichten (110, 120) versehen sind.

8. Packung nach Anspruch 7,
dadurch gekennzeichnet, daß die untere und die obere Folie (11, 12) im Versiegelungsbereich (13) durch Druckanwendung miteinander verklebt sind.

9. Packung nach Anspruch 4,
dadurch gekennzeichnet, daß die untere Folie (11) aus festem Material besteht und mit mindestens einer konvexen Tasche (16) versehen ist, um die elektrische Schaltungsplatine (20) aufzunehmen.

10. Verfahren zum Herausnehmen von elektrischen Schaltungsplatinen aus den Taschen (14) einer Packung (10) nach einem der Ansprüche 1-3, gekennzeichnet durch die folgenden Schritte:
Abziehen der länglichen Folien (11 und 12) in entgegengesetzte Richtungen, um die Folien voneinander zu trennen, wobei der Versiegelungsbereich (13) aufgebrochen wird; und
Herausnehmen der elektrischen Schaltungsplatinen (20) aus den voneinander getrennten Folien (11 und 12).

11. Verfahren nach Anspruch 10,
gekennzeichnet durch die weiteren Schritte:
Fördern der Packung (10) zwischen einem Paar von Trennwalzen (40 und 50);
individuelles Aufwickeln der durch Abziehen voneinander getrennten Folien (11 und 12); und
Herausnehmen der elektrischen Schaltungsplatinen (20), die von den voneinander getrennten Folien (11 und 12) freigegeben werden.

12. Vorrichtung zum Herausnehmen von elektrischen Schaltungsplatinen (20) aus einer Packung (10) gemäß Anspruch 1, wobei die Schaltungsplatinen (20) in Taschen (14) angeordnet sind, die in einer kontinuierlichen Reihe zwischen einer unteren Folie (11) und einer oberen Folie (2) aus undurchlässigem Material liegen, die miteinander versiegelt sind und die Packung (10) bilden, die zu beiden Seiten der Taschen mit Perforationen (15) versehen ist, gekennzeichnet durch
ein Führungsmittel (32) zum Führen der Packung (10);
eine Trenneinrichtung (65) zum Abziehen und Trennen der Folien (11 und 12) der Packung (10) voneinander, wobei die Trenneinrichtung folgende Teile aufweist: eine obere Walze (40) mit Trennabschnitten (41) an beiden Enden, die in gleichmäßigen Abständen um den Umfang verteilt eine Mehrzahl von Zähnen (43) entsprechend den Perforationen (15) an der Packung (10) aufweisen, und eine untere Walze (50) mit Löchern (53) am Umfang entsprechend den Zähnen (43), wobei die Packung (10) zwischen den Walzen (40 und 50) so gehalten wird, daß die Zähne (43) durch die Perforationen (15) der Packung (10) in die Löcher (53) greifen;
Aufwickeleinrichtungen (49 und 59) zum Aufwickeln der getrennten Folien (11, 12) der Packung; und
eine Sammelvorrichtung (90) zum Sammeln der elektrischen Schaltungsplatinen (20) aus den geöffneten Packungen (10).

13. Vorrichtung nach Anspruch 12,
dadurch gekennzeichnet, daß die Trenneinrichtung (65) folgende Teile aufweist:
einen an der oberen Walze (40) ausgebildeten, zentralen Wellenabschnitt (42) mit einer Durchgangsbohrung (44), die sich von einem Ende zum anderen Ende erstreckt;
einen an der unteren Walze (50) ausgebildeten, zentralen Wellenabschnitt (52) mit einer Durchgangsbohrung (54), die sich von einem Ende zum anderen erstreckt; und
Mittel zum Zuführen eines Heizungsmediums, das durch die Bohrungen (42 und 52) über die Enden zirkuliert und die oberen und unteren Trennabschnitte (41 und 52) aufheizt, damit der Versiegelungsbereich (13a) entlang der einander gegenüberliegenden Seiten der Packung (10) während des Trennschrittes schmilzt.

14. Vorrichtung nach Anspruch 12 oder 13,
gekennzeichnet durch eine Stanzvorrichtung (62), die vor der Trenneinrichtung (65) einen oberen Stempel (60) und einen unteren Stempel (61) aufweist, derart, daß die Packung (10) zwischen dem oberen Stempel (60) und dem unteren Stempel (61) durchläuft; wobei der obere Stempel (60) in vertikaler Richtung auf- und abbewegt wird und in den unteren Stempel (61) eingreift; so daß während des Stanzvorganges die Stanzvorrichtung (62) die Packung (10) an einem Abschnitt (18) des Versiegelungsbereiches (13b) abschneidet, der quer über die Packung (10) verläuft.

15. Vorrichtung nach einem der Ansprüche 12-14,
gekennzeichnet durch ein Paar von Heizeinrichtungen (70 und 71) vor der Trenneinrichtung (65); wobei die Heizeinrichtungen (70 und 71) aufeinander zubewegt werden, um die Packung (10) zwischen sich in einem Abschnitt des Versiegelungsbereiches (13b) zu halten, der in Querrichtung zur Packung (10) verläuft; wobei während dieses Trennvorganges die Heizeinrichtungen (70 und 71) die Packung (10) im Versiegelungsbereich (13b) zum Schmelzen halten.

16. Vorrichtung nach Anspruch 15,
gekennzeichnet durch ein Ionen erzeugendes Mittel (75) zwischen den Heizeinrichtungen (70 und 71) und der Trenneinrichtung (65) zum Entfernen statischer elektrischer Ladungen von den elektrischen Schaltungsplatinen (20).

17. Vorrichtung nach einem der Ansprüche 12-16,
gekennzeichnet durch eine ultraviolette Strahlen erzeugende Einrichtung (80) zum Abgeben von ultravioletten Strahlen auf die Packung (10) im Bereich einer Tasche (14) einschließlich des Versiegelungsbereiches (13b) vor der Trenneinrichtung (65).

## Revendications

1. Procédé de protection d'une plaquette de circuit électrique comportant un moyen de circuit électrique en un matériau conducteur aisément oxydable du fait d'une oxydation pendant le stockage ou le transport entre le lieu de fabrication de la plaquette et le lieu de montage et de soudage des composants électriques ou électroniques sur la plaquette,
caractérisé par :
le placement de la plaquette de circuit électrique dans un emballage dans une atmosphère de non oxydation pendant le stockage ou le transport, l'emballage comprenant une feuille inférieure constituée par un matériau imperméable au gaz, une feuille supérieure constituée par un matériau imperméable au gaz, une zone liée sur la périphérie des surfaces desdites feuilles qui sont disposées de manière à se faire face l'une l'autre, au moins une cavité étant définie entre ladite feuille inférieure et ladite feuille supérieure et fermée d'une manière étanche à l'air par ladite zone liée, et le placement de la plaquette de circuit électrique dans ladite cavité, sans composants électriques ou électroniques pendant le stockage ou le transport, dans une atmosphère de non oxydation dans ladite cavité ; et
l'extraction des plaquettes de circuit électrique hors des cavités peu de temps avant le montage et le soudage des composants sur la plaquette.

2. Procédé selon la revendication 1, dans lequel ladite atmosphère de non oxydation est un gaz inerte.

3. Procédé selon la revendication 1, dans lequel ladite atmosphère de non oxydation est une atmosphère résultant d'un vide qui est fait dans ladite cavité.

4. Emballage contenant des plaquettes de circuit électrique destinées à être utilisées en relation avec un procédé selon l'une quelconque des revendications précédentes, caractérisé par :
une feuille inférieure (11) réalisée en un matériau imperméable au gaz ;
une feuille supérieure (12) réalisée en un matériau imperméable au gaz ;
une zone liée (13) sur la périphérie des surfaces desdites feuilles (11, 12) qui sont positionnées de manière à se faire face l'une l'autre ;
au moins une cavité (14) définie entre ladite feuille inférieure (11) et ladite feuille supérieure (12) et fermée par ladite zone liée (13) d'une manière étanche à l'air ;
une plaquette de circuit électrique (20) contenue dans ladite cavité (14) et comportant sur elle un moyen de circuit électrique (22) en un matériau conducteur aisément oxydable et exempt de composants électriques ou électroniques ; et
une atmosphère de non oxydation dans ladite cavité.

5. Emballage selon la revendication 4, dans lequel ledit matériau imperméable au gaz est un matériau en résine et ladite zone liée (13) est liée par fusion au moyen de l'application de chaleur.

6. Emballage selon la revendication 4, dans lequel ladite zone liée (13) est fondue et collée au moyen d'une technique de liaison par fusion.

7. Emballage selon la revendication 4, dans lequel lesdites feuilles supérieure et inférieure comprennent en outre des couches visqueuses et adhésives (110, 120) sur des surfaces s'opposant l'une l'autre, au moins dans ladite zone liée (13).

8. Emballage selon la revendication 7, dans lequel lesdites feuilles supérieure et inférieure (11, 12) sont amenées à adhérer par pression l'une à l'autre dans ladite zone liée (13).

9. Emballage selon la revendication 4, dans lequel ladite feuille inférieure (11) est réalisée en un matériau rigide comportant au moins un renfoncement convexe (16) ménagé en son sein pour recevoir ladite plaquette de circuit électrique (20).

10. Procédé d'extraction de plaquettes de circuit électrique hors de cavités (14) d'un emballage (10) selon l'une quelconque des revendications 1 à 3, caractérisé par les étapes de :
application d'une traction séquentiellement sur lesdites feuilles allongées (11 et 12) suivant des directions opposées de manière à séparer lesdites feuilles l'une de l'autre tandis que ladite zone liée (13) est libérée ; et
extraction desdites plaquettes de circuit électrique (20) hors desdites feuilles séparées (11 et 12).

11. Procédé selon la revendication 10, comprenant en outre les étapes de :
convoyage dudit emballage (10) entre une paire de rouleaux de séparation (40 et 50) ;
enroulement desdites feuilles (11 et 12) individuellement lorsque les feuilles sont séparées par ladite traction ; et
extraction desdites plaquettes de circuit électrique (20) libérées desdites feuilles séparées (11 et 12).

12. Appareil d'extraction de plaquettes de circuit électrique (20) d'un emballage (10) selon la revendication 1, dans lequel les plaquettes de circuit (20) sont logées dans des cavités (14) agencées selon une ligne continue entre une feuille inférieure (11) et une feuille supérieure (12) en un matériau imperméable liées ensemble et formant l'emballage (10), comportant des trous perforés (15) sur les deux côtés des cavités,
caractérisé par :
un moyen de guidage (32) pour guider ledit emballage (10) ;
un moyen de séparation (65) pour exercer une traction et provoquer une séparation desdites feuilles (11 et 12) dudit emballage (10) l'une par rapport à l'autre, le moyen de séparation comprenant :
un rouleau supérieur (40) comportant des rouleaux de séparation (41) prévus sur ses extrémités opposées et munis d'une pluralité de dents (43) espacées selon une distance prédéterminée sur la circonférence externe en correspondance avec les trous perforés (15) formés sur ledit emballage (10) ; et
un rouleau inférieur (50) comportant des trous (53) formés sur sa circonférence externe en correspondance avec lesdites dents (43), ledit emballage (10) étant maintenu entre lesdits rouleaux (40 et 50) de telle sorte que lesdites dents (43) s'engrènent dans lesdits trous (53) par l'intermédiaire desdits trous perforés (15) dudit emballage (10) ;
un moyen d'enroulement (49 et 59) pour enrouler lesdites feuilles séparées (11, 12) de l'emballage (10) ; et
un moyen de collecte (90) pour collecter lesdites plaquettes de circuit électrique (20) à partir dudit emballage ouvert (10).

13. Appareil selon la revendication 12, dans lequel ledit moyen de séparation (65) comprend en outre un arbre central (42) comportant un trou de passage (44) s'étendant depuis une extrémité jusqu'à une autre extrémité de lui-même, prévu sur ledit rouleau supérieur (40) ; un arbre central (52) comportant un trou de passage (54) s'étendant depuis une extrémité jusqu'à une autre extrémité de lui-même, prévu sur ledit rouleau inférieur (50) ; et un moyen pour assurer la circulation d'un milieu chauffé à l'intérieur desdits trous de passage (42 et 52) via lesdites extrémités de ceux-ci, d'où le chauffage desdits rouleaux supérieur et inférieur (41 et 51) afin de fondre la zone liée (13a) le long de côtés opposés dudit emballage (10) pendant la séparation.

14. Appareil selon la revendication 12 ou 13, comportant en outre un dispositif de coupe (62) comportant un poinçon supérieur (60) et un poinçon inférieur (61) prévus avant le moyen de séparation (65) de telle sorte que l'emballage (10) passe au travers de l'espace situé entre ledit poinçon supérieur (60) et ledit poinçon inférieur (61) ; ledit poinçon supérieur (60) étant prévu de manière à se déplacer de façon alternée verticalement de manière à s'emboîter dans ledit poinçon inférieur (61) et ainsi, pendant la séparation, ledit dispositif de coupe (62) découpe ledit emballage (10) au niveau d'une partie (18) de la zone liée (13b) traversant l'emballage (10).

15. Appareil selon l'une quelconque des revendications 12 à 14, comprenant en outre une paire de moyens de chauffage (70 et 71) avant ladite unité de séparation (65) ; lesdits moyens de chauffage (70 et 71) étant déplacés l'un vers l'autre pour maintenir ledit emballage (10) entre au niveau d'une partie de la zone liée (13b) traversant ledit emballage (10) et ainsi, pendant la séparation, lesdits moyens de chauffage (70 et 71) pressent ledit emballage (10) au niveau de ladite zone liée (13b) pour la fondre.

16. Appareil selon la revendication 15, comprenant en outre un moyen de génération d'ions (75) entre lesdits moyens de chauffage (70 et 71) et ledit moyen de séparation (65) pour ôter des charges électriques statiques hors desdites plaquettes de circuit électrique (20).

17. Appareil selon l'une quelconque des revendications 12 à 16, comprenant en outre un moyen de génération de rayons ultraviolets (80) pour irradier des rayons ultraviolets sur ledit emballage (10) au niveau d'une zone incluant une cavité (14) entourée par des zones liées (13b) avant ledit moyen de séparation (65).
